# EUROPEAN PATENT APPLICATION

(11) **EP 4 657 511 A1**
(43) Date of publication of application: **03.12.2025**
(21) Application number: 24178178.0
(22) Date of filing: 27.05.2024
(51) Int. Cl.: H01L 21/67, H01L 21/683

(54) **DIE BONDING APPARATUS AND DIE POSITIONING METHOD USING THE DIE BONDING APPARATUS**

(71) Applicant: ETEL S.A., 2112 Môtiers (CH)
(72) Inventor: Sudarsandhari Shibani, Willson, 2000 Neuchâtel (CH)
(74) Representative: P&TS SA (AG, Ltd.)

(57) **Abstract**

The invention relates to a die positioning method using die bonding apparatus (10) comprising a carriage (12), a linear encoder comprising an encoder scale (20) and a first and a second encoder heads (22a, 22b) mounted on the carriage. The carriage comprises a bond-head (14) and a camera (16). The central axis of the bond-head (14) and the optical axis of the camera (16) are distant from each other along the traveling direction by a first distance (D1). The first and second encoder heads (22a, 22b) are distant from each other along said traveling direction by a second distance corresponding to said first distance and an offset corresponding to an alignment error between said first and second encoder heads and the central axis of the bond-head and the optical axis of the camera respectively. The method comprises the steps of: a) finding with the camera (16) of the carriage (12) a target location (30) for positioning a die (50), b) measuring or recording an alignment error (ΔX) between the camera optical axis and said target location (30), c) recording a difference (δ) between said first distance (D1) and said second distances (D2), d) recording a position (P1) of the carriage (12) with the first encoder head (22a; 122a), e) aligning the bond-head (14) with said target location (30) by moving the carriage (12) as a function of: i) the outputs of the first and second encoder heads (22a, 22b; 122a, 124a), ii) said recorded difference (δ), and iii) optionally said alignment error (ΔX), and f) actuating the bond-head (14) in the Z-direction to place the die at said target location (30).

## Description

### Field of the invention

The present invention relates to the field of the semiconductor industry and more particularly to a die bonding method for accurate positioning of the die before bonding. The invention also relates to a die bonding apparatus for carrying out the die bonding method. The die bonding apparatus and method are particularly suited for hybrid bonding applications requiring high-accuracy placement of the dies down to the range of ±50nm placement error.

### Background of the invention

Die bonding is extensively used for attaching or bonding a semiconductor chip, also known as a die, onto a substrate or a package. Die bonding can be performed using various techniques, including wire bonding, flip chip bonding and adhesive bonding. Die bonding plays a crucial role in creating the electrical connections necessary for the functionality of semiconductor devices. Precise positioning of dies is a fundamental aspect of semiconductor manufacturing to achieve optimal electrical performance, functionality, reliability and consistency in the final semiconductor devices.

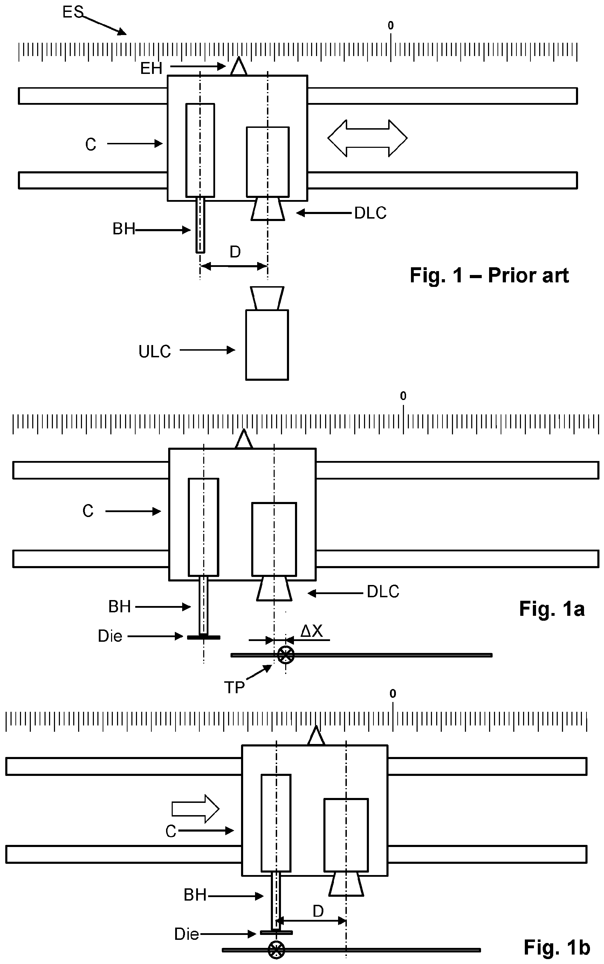

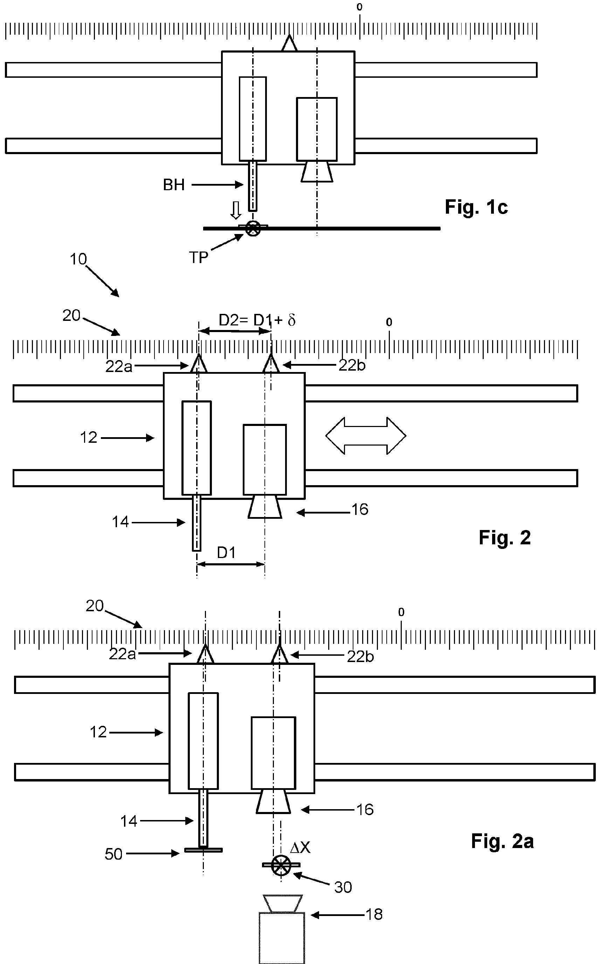

Conventional die bonding systems, as shown in Figures 1 to 1c, comprise a carriage C comprising a bond-head BH and a down-looking camera DLC to be able to measure the position of the pads on the PCB for increased die placement accuracy. The down-looking camera DLC and the bond-head BH are attached to the carriage C at a fixed distance D as shown in Figure 1. The carriage C is slidably engaged with rails to move along an encoder scale ES. The movements of the carriage C are measured with a single encoder head EH mounted on the carriage C and arranged to move along and above the encoder scale ES. The distance D between the down-looking camera DLC and the bond-head BH is measured using the encoder and an up-looking camera ULC while the carriage C is moved to search for the central axis of the bond-head BH and the optical axis of the camera DLC. The down-looking camera DLC is used to measure on the PCB the exact location of the pads onto which the die must be bonded. The camera DLC measures an alignment error *ΔX* between a target location TP and the optical axis of the down-looking camera DLC as shown in Figure 1a. The carriage C is then moved by a distance *D*+*ΔX* so that the bond-head BH is above the target location to place the die as shown in Figure 1b and 1c.

The placement accuracy of these systems is not optimal as different placement errors may occur. In particular, the heat generated by the motors causes the thermal expansion of the encoder scale over *D*+*ΔX* as well as the thermal expansion of the carriage C which has a direct impact on the distance *D* between the bond-head and the camera. The scale engraving defects over *D*+*ΔX* has also a negative impact on the placement accuracy of these systems.

Yet, in hybrid bonding applications, dies are stacked on top of each other in packages using small copper-to-copper connections and therefore require the utmost placement accuracy of the dies down to the range of ±50nm placement error.

Positioning systems comprising two encoder heads for compensating measurement errors due to thermal expansion of an encoder scale are also known. EP2636991A1 for example relates to a measuring machine provided with a system for compensating measurement errors due to thermal expansion of a scale of a linear transducer. Encoder heads are used to calculate a scale factor based on the distance between the two encoder heads and their respective readings to compensate for thermal expansion of the scale.

DE19919042A1 discloses a thermally compensated positioning system comprising a scale support supporting a scale and a carriage arranged to move along the scale and comprising two encoder heads spaced apart from each other by a predefined distance along the travel direction of the carriage. These two encoder heads are each configured to detect a reference mark and to feed to an evaluation unit two signals associated with that reference mark to compensate the encoder scale thermal expansion by using the relative distance between the two encoder heads that changes with temperature.

Other thermally compensated positioning systems comprising two encoder heads are disclosed for example in DE102021118091A1, DE102021118092A1, EP2527797A1 and EP3982088A1. In general, these positioning systems rely on multiple sensing units on the same scale to compensate for temperature or calibrate the scale. Scale mapping is usually used for thermal expansion compensation which is tedious and time consuming.

### Brief summary of the invention

An aim of the present invention is therefore to provide a die bonding apparatus and a die positioning method for accurate positioning of the die before bonding which are exempt of the above limitations.

More particularly, an aim of the present invention is to provide a die bonding apparatus for highly accurate positioning of dies down to the range of ±50nm placement error.

Another aim of the present invention is to provide a die positioning method wherein the die placement is insensitive to thermal expansion notably of the encoder scale.

A further aim of the present invention is to provide a die positioning method wherein the die placement is insensitive to scale engraving defects.

These aims are achieved notably by a die bonding apparatus comprising a linear motor, a carriage arranged to be driven by the linear motor along a traveling direction, a linear encoder comprising an encoder scale extending along the travel direction of the carriage, at least a first and a second encoder heads mounted on the carriage, and a controller arranged to move said carriage as a function of the values read by respective first and second encoder heads to align the bonding head with a target location. The carriage comprises a bond-head configured to pick up a die and a camera configured to detect the target location for positioning the die and for measuring an alignment error between the optical axis of the camera and said target location. The central axis of the bond-head and the optical axis of the camera are distant from each other along the traveling direction by a first distance. The first and second encoder heads are distant from each other along said traveling direction by a second distance corresponding to said first distance and an offset corresponding to an alignment error between said first and second encoder heads and the central axis of the bond-head and the optical axis of the camera respectively.

In an embodiment, the first and second encoder heads are aligned with the central axis of the bond-head and the optical axis of the camera respectively with an alignment error.

In an embodiment, the central axis of the bonding head intersects the center of the die when carried by said bonding head for die positioning on said target location.

In an embodiment, the die bonding apparatus further comprises a transverse beam, and two additional motion axes slidably engaged with said transverse beam and extending orthogonally thereof. The carriage is slidably mounted along the transverse beam. The linear encoder is a 1Dplus encoder comprising a linear scale having an incremental track and an additional track, a first and a second set of encoder heads arranged in correspondence with respectively the bond-head and the camera of the carriage. Each set of encoder heads comprises a Y-encoder head arranged to scan the incremental track and a least one X-encoder head arranged to scan the additional track for position correction of the transverse beam using said additional motion axes.

In an embodiment, each set of encoder heads comprises two X-encoder heads for angular correction of the bond-head and the camera using the additional motion axes.

In an embodiment, wherein said X-encoder heads of said first and second sets of encoder heads are arranged on both sides of respective bond-head and camera.

In an embodiment, the Y-encoder head of said first and second sets of encoder heads are aligned with the central axis of the bond-head and the optical axis of the camera respectively with an alignment error.

Another aspect of the present invention relates to a die positioning method using the die bonding apparatus according to any of the above described embodiments, wherein the method comprises the following steps:
a) finding with the camera of the carriage a target location for positioning the die,
b) measuring or recording an alignment error between the camera optical axis and said target location,
c) recording a difference between said first and second distances,
d) recording a position of the carriage with the first encoder head,
e) aligning the bond-head with said target location by moving the carriage as a function of: i) the outputs of the first and second encoder heads, ii) said recorded difference, and optionally said alignment error, and
f) actuating the bond-head in the Z-direction to place the die at said target location.

In an embodiment, the die positioning method comprises the steps of
performing micro-alignments to reduce as much as possible the alignment error preferably below 10nm, according to the feedback of the camera, and
moving the carriage to position the second encoder head at the position recorded by the first encoder head with an offset corresponding to the recorded difference between the first and second distances.

In an embodiment, the die positioning method comprises the steps of
- recording the alignment error between the camera optical axis and said target location, and
- moving the carriage to position the second encoder head at the position recorded by the first encoder head with an offset combining the alignment error and the recorded difference between the first and second distances.

In an embodiment, the die bonding apparatus further comprises a an up-looking camera placed below the target location and orientated to face the carriage. The die positioning method further comprises a calibration step performed prior to initiating the die placement at the target location. The calibration step consists in
driving the carriage to move the camera and the bond-head above the up-looking camera to enable the latter to measure the first distance, and
further driving the carriage in the same direction such that the first and second encoder heads move across a reference mark of the encoder scale to measure the second distance in order to determine the encoder heads alignment error as a function of the measured first distance.

In an embodiment, an offset value between the central axis of the bond-head and the center of the die carried by said bond-head is measured using the up-looking camera. The offset value is used to correct the position of the carriage for accurate positioning of the die at the target location independently of the amplitude of the offset value.

Another aspect of the invention relates to a die positioning method using the die bonding apparatus, wherein the method comprises the following steps:
- finding with the camera a target location for positioning the die,
- recording a misalignment between the camera optical axis and said target location,
- moving the carriage as a function of the signal outputs acquired by respective first and second said first and second sets of encoder heads to align the bond-head along the X-Y direction and around the Z-axis with said target location, and
- actuating the die bond-head in the Z-direction to place the die at said target location.

### Brief description of the drawings

The invention will be better understood with the aid of the description of embodiments given by way of examples and illustrated by the figures, in which:
- Figure 1 shows a schematic view of a die bonding apparatus according to the prior art;
- Figures 1a to 1c show a sequence of movements for placing a die at a target location using the die bonding apparatus of Figure 1;
- Figure 2 shows a schematic view of a die bonding apparatus according to an embodiment,
- Figures 2a to 2c show a sequence of movements of a method, according to an embodiment, for placing a die at a target location using the die bonding apparatus of Figure 2,
- Figure 3 shows a schematic view of a bonding apparatus according to another embodiment, and
- Figure 4 shows a schematic view of a die bonding apparatus according to a further embodiment.

### Detailed description of several embodiments of the invention

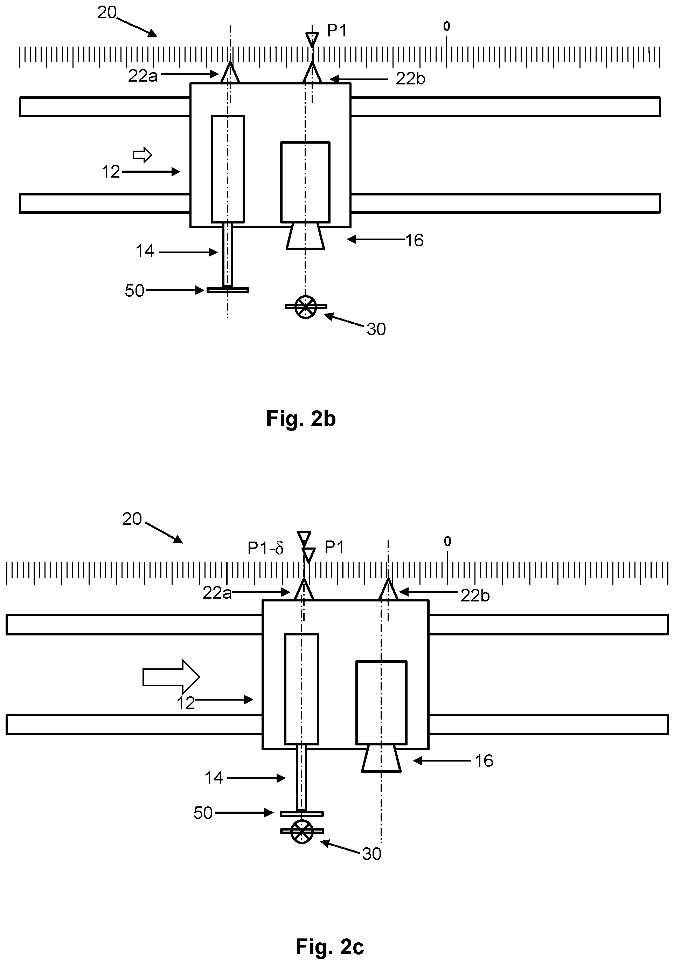

With reference to the embodiment illustrated in Figure 2, the die bonding apparatus 10 comprises a linear motor (not shown), and a carriage 12 arranged to be driven by the motor along a traveling direction. The carriage 12 comprises a bond-head 14 configured to pick up a die 50 (Figure 2a) and a first camera 16 configured detect a target location 30 for positioning the die 50. The camera 16 and the bond-head 14 are mounted on the carriage 12 with a first distance D1 between the optical axis of the camera 16 and the central axis of the bond-head 14 along the travel direction of the carriage 12.

The die bonding apparatus 10 further comprises a linear encoder having a scale 20 extending along the travel direction of the carriage 12, a first and a second encoder head 22a, 22b mounted on the carriage 12 and a controller configured to move the carriage 12 as a function of the values read by respective first and second encoder heads 22a, 22b to align the die 50 with the target location 30. The first and second encoder heads 22a, 22b are separated from each other along the travel direction of the carriage 12 by a second distance D2 as shown in Figure 2.

In a preferred embodiment, the two encoder heads 22a, 22b are positioned as close as possible in alignment with respective camera optical axis and the bond-head central axis. There is however always encoder heads alignment error δ with respective camera 16 and bond-head 14 which must be taken into account for the utmost accurate positioning of the die. The second distance D2 between the two encoder heads 22a, 22b corresponds therefore to the first distance D1 and an offset corresponding to the encoder heads alignment error δ as illustrated in Figure 2.

As explained above, the linear encoder is sensitive to thermal expansion induced in particular by the heat generated by the motors. The encoder scale 20 generally expands in its longitudinal direction when the bonding apparatus 10 is in operation which induces a measurement error on the scale. The first distance D1 between the optical axis of the camera 16 and the central axis of the bond-head 14 may also vary according to the thermal expansion of the carriage 12. The scale 20 may also have engraving defects. All these parameters must be taken into account for the utmost accurate placement of the die 50 at the target location 30.

Advantageously, the die placement by the die positioning method described subsequently is insensitive to these parameters.

A calibration step is needed prior to initiating the die placement to measure the first and second distances D1 and D2 and to determine the encoder heads alignment error δ.

In this regard, the die bonding apparatus 10 further comprises a second camera 18, as shown in Figure 2a, which is placed below the target location 30 and orientated to face the carriage 12. The latter is driven to move the first camera 16 and the bond-head 14 above the second camera 18 to enable the latter to measure the first distance D1. The carriage 12 is then further driven in the same direction such that the first and second encoder heads 22a, 22b move across the reference mark "0" of the encoder scale 20 to measure the second distance D2 in order to determine the encoder heads alignment error δ as a function of the measured first distance D1.

Referring to Figure 2a, once the calibration step is completed, the die positioning method consists in driving the carriage 12 to align the optical axis of the first camera 16 with the target location 30. More particularly, the camera 16 measures an alignment error ΔX between the camera optical axis and the target location 30. The signal output of the camera 16 is sent to the motor controller to drive the motor so as to perform several micro-alignments to reduce as much as possible the alignment error ΔX preferably below 10nm.

The first encoder head 22a then reads the position P1 on the encoder scale 20. The motor controller then drives the motor to move the carriage 12 as a function of signal outputs of the first and second encoder heads 22a, 22b and according to the encoder heads alignment error δ such that the second encoder head 22b is moved to the position P1 - δ. The central axis of the bond-head 14 is thus aligned with the target location 30 with an accuracy below 10nm. The bond-head 14 is then actuated in the Z-direction to bond the die 50 on top of another die with the utmost accuracy.

It is thus readily apparent that any thermal expansion and/or any engraving defects of the encoding scale 20 does not have any repercussion on the placement accuracy of the die 50 since the discrete position P1 at which the second encoder head 22b is brought remains at a fixed point independently of the thermal expansion/engraving defects parameters. This also highlights the need to make the encoder heads alignment error δ as small as possible so that the target position P1 - δ of the second encoder head 22b is as close as possible to the position P1.

In another embodiment, the die positioning method consists in aligning the bond-head 14 with the target location 30 without performing the above step of micro-alignments of the camera axis. Instead, the alignment error ΔX between the camera axis and the target location 30 is first recorded and the motor controller drives the carriage 12 as a function of the signal outputs of respective first and second encoder heads 22a, 22b and according to the encoder heads alignment error δ such that the second encoder 22b is moved to the position P1 - δ + ΔX. The die positioning method according to this embodiment has the advantage to be faster at the expense of the accuracy. Indeed, the accuracy obtained is the local accuracy over ΔX meaning that any thermal expansion and/or any scale engraving error occurring over ΔX would directly impact the placement accuracy of the die.

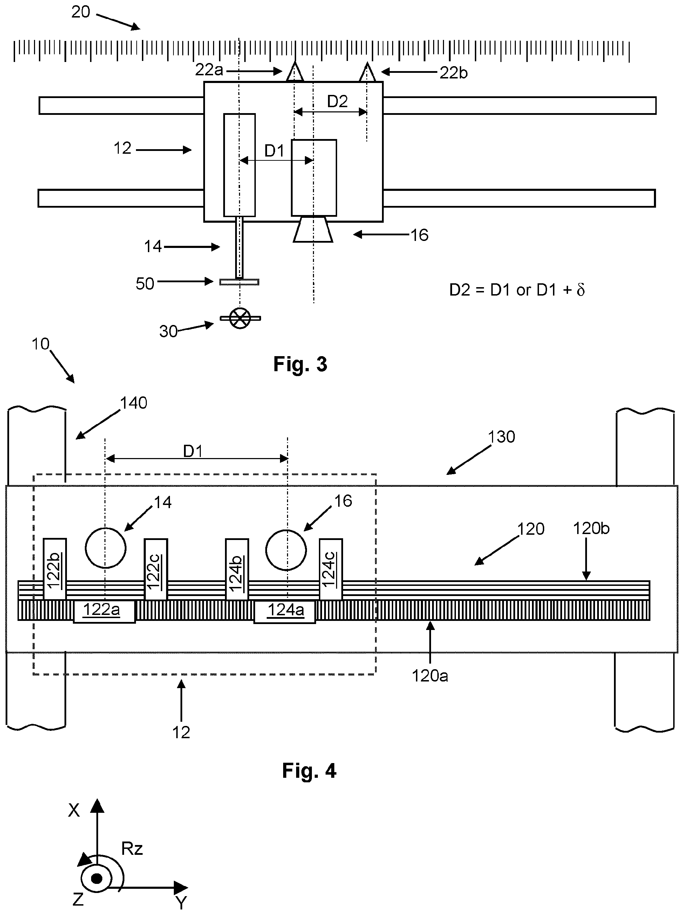

According to another embodiment schematically illustrated in Figure 3, the camera 16 and the bond-head 14 are mounted on the carriage 12 with a distance D1 between the camera optical axis and the bond-head central axis along the travel direction of the carriage 12. The first and second encoder heads 22a, 22b are mounted on the carriage 12 such that they are offset with respect to the camera optical axis and the bond-head central axis along the travel direction. The distance D2 between the encoder heads 22a, 22b remains however the same distance as the first distance D1 with an offset corresponding to an alignment error δ.

The placement of the die 50 at the target location 30 may be however less accurate according to this embodiment considering that the portion of the carriage 12 within the distance D1 may have a slightly different behavior compared to the portion of the carriage 12 within the distance D2 in terms of thermal expansion when subjected to the heat of the motor.

In a preferred embodiment, an offset value between the central axis of the bond-head 14 and the center of the die 50 carried by the bond-head 14 for die positioning at the target location 30 is measured using the up-looking camera 18. The measured offset value is then fed to the controller of the motor to correct the position of the carriage 12. This ensures accurate positioning of the die 50 in case the center of the latter is misaligned with the bond-head central axis.

According to another embodiment schematically illustrated in Figure 4, the die bonding apparatus 10 comprises a Y-beam 130 slidably engaged with two motion axes 140 in the X direction and a carriage 12 mounted to move along the Y-beam and comprising a bond-head 14, a camera 16 and two set of encoder heads arranged to read a 1Dplus scale 120 featuring an incremental track 120a along the Y-direction as well as additional track 120b that provides the information required for compensation in the perpendicular direction and for angular correction.

The first set of encoder heads comprises a Y-encoder head 122a arranged on the incremental track 120a of the 1Dplus scale 120 and two X-encoder heads 122b, 122c arranged on the additional track 120b on both sides of the bond-head 14. The second set of encoder heads comprises a Y-encoder head 124a arranged on the incremental track 120a of the 1Dplus scale 120 and two X-encoder heads 124b, 124c arranged on the additional track 120b on both sides of the camera 16.

The alignment of the bond-head 14 along the Y-direction is performed by moving the carriage 12 according to the die positioning method described in relation with the embodiments of Figure 2 to 2c using the Y-encoder head 122a, 124a of respective first and second sets. The two X-encoder heads 122b, 122c, 124b, 124c are arranged to compensate for alignment errors in the X-direction and angular error in the Rz-direction using motion axes 140.

While the invention has been illustrated and described in detail in the drawings and foregoing description, such illustration and description are to be considered illustrative or exemplary and not restrictive. It will be understood that changes and modifications may be made by those of ordinary skill within the scope of the appended claims. For example, the die positioning method using the die bonding apparatus may be adapted for a 6-DOF positioning system with multiples encoders.

### Reference list

Die bonding apparatus 10
   Carriage 12
   Bond-head 14
   First Camera 16
   Second camera 18
   Encoder scale 20
   First and second encoder heads 22a, 22b
   1Dplus encoder scale 120
      Incremental track 120a
      Additional track 120b
   First encoder assembly
      Y-encoder head 122a
      Two X-encoder heads 122b, 122c
   Second encoder assembly
      Y-encoder head 124a
      Two X-encoder heads 124b, 124c
   Y-beam 130
   Motion axes 140
Target location 30
Camera alignment error ΔX with the target location
Encoder heads alignment error δ with respective camera and bond-head
Distance between camera and the bond head D1
Distance between the two encoder heads D2
Die 50

## Claims

1. Die bonding apparatus (10) comprising a linear motor, a carriage (12) arranged to be driven by the linear motor along a traveling direction, said carriage (12) comprising a bond-head (14) configured to pick up a die (50) and a camera (16) configured detect a target location (30) for positioning the die (50) and for measuring an alignment error (ΔX) between the optical axis of the camera (16) and said target location (30), wherein the central axis of the bond-head (14) and the optical axis of the camera (16) are distant from each other along said traveling direction by a first distance (D1), the die bonding apparatus (10) further comprising a linear encoder comprising an encoder scale (20) extending along the travel direction of the carriage (12), at least a first and a second encoder heads (22a, 22b; 122a, 122b, 122c, 124a, 124b, 124c) mounted on the carriage (12), and a controller arranged to move said carriage (12) as a function of the values read by respective first and second encoder heads (22a, 22b) to align the bonding head (50) with said target location (30), wherein the first and second encoder heads are distant from each other along said traveling direction by a second distance (D2) corresponding to said first distance (D1) and an alignment error (δ) between said first and second encoder heads and the central axis of the bond-head (14) and the optical axis of the camera (16) respectively.

2. The die bonding apparatus (10) according to claim 1, wherein said first and second encoder heads (22a, 22b) are aligned with the central axis of the bond-head (14) and the optical axis of the camera (16) respectively with an alignment error (δ)

3. The die bonding apparatus (10) according to any preceding claim, wherein the central axis of the bonding head (14) intersects the center of the die (50) when carried by said bonding head for die positioning on said target location (30).

4. The die bonding apparatus (10) according to any preceding claim, further comprising a transverse beam (130), and two motion axes (140) slidably engaged with said transverse beam (130) and extending orthogonally thereof, wherein the carriage (12) is slidably mounted along the transverse beam (130) and wherein the linear encoder is a 1Dplus encoder comprising a linear scale (120) having an incremental track (120a) and an additional track (120b), and a first and a second set of encoder heads arranged in correspondence with respectively the bond-head (14) and the camera (16) of the carriage, each set of encoder heads comprising a Y-encoder head (122a, 124a) arranged to scan the incremental track (120a) and a least one X-encoder head (122b, 122c; 124b, 124c) arranged to scan the additional track (120b) for position correction of the transverse beam (130) using said motion axes (140).

5. The die bonding apparatus (10) according to the preceding claim, wherein each set of encoder heads comprises two X-encoder heads (122b, 122c; 124b, 124c) for angular correction (RZ) of the bond-head (14) and the camera (16).

6. The die bonding apparatus (10) according to the preceding claim, wherein said X-encoder heads (122b, 122c; 124b, 124c) of said first and second sets of encoder heads are arranged on both sides of respective bond-head (14) and camera (16).

7. The die bonding apparatus (10) according to any of claims 4 to 6, wherein the Y-encoder head (122a, 124a) of said first and second sets of encoder heads are aligned with the central axis of the bond-head (14) and the optical axis of the camera (16) respectively with an alignment error (δ).

8. Die positioning method using the die bonding apparatus (10) according to any preceding claim, wherein the method comprises the following steps:
a) finding with the camera (16) of the carriage (12) a target location (30) for positioning the die (50),
b) measuring or recording an alignment error (ΔX) between the camera optical axis and said target location (30),
c) recording a difference (δ) between said first distance (D1) and said second distances (D2),
d) recording a position (P1) of the carriage (12) with the first encoder head (22a; 122a),
e) aligning the bond-head (14) with said target location (30) by moving the carriage (12) as a function of: i) the outputs of the first and second encoder heads (22a, 22b; 122a, 124a), ii) said recorded difference (δ), and iii) optionally said alignment error (ΔX), and
f) actuating the bond-head (14) in the Z-direction to place the die at said target location (30).

9. The die positioning method according to the preceding claim, comprising the steps of:
performing micro-alignments to reduce as much as possible the alignment error (ΔX) preferably below 10nm, according to the feedback of the camera (16), and
moving the carriage (12) to position the second encoder head (22b; 124a) at the position recorded by the first encoder head (22a, 122a) with an offset corresponding to the recorded difference (P1 - δ).

10. The die positioning method according to claim 8, comprising the steps of
- recording the alignment error (ΔX) between the camera optical axis and said target location (30), and
- moving the carriage (12) to position the second encoder head (22b; 124a) at the position recorded by the first encoder head (22a, 122a) with an offset combining the recorded difference (δ) and the alignment error (ΔX).

11. The die positioning method according to any of claims 8 to 10, wherein the die bonding apparatus (10) further comprises an up-looking camera (18) placed below the target location (30) and orientated to face the carriage (12) and wherein a calibration step is performed prior to initiating the die placement, said calibration step consisting in
driving the carriage (12) to move the camera (16) and the bond-head (14) above the up-looking camera (18) to enable the latter to measure the first distance (D1),
further driving the carriage (12) in the same direction such that the first and second encoder heads (22a, 22b) move across a reference mark ("0") of the encoder scale (20) to measure the second distance (D2) in order to determine the encoder heads alignment error (δ ) as a function of the measured first distance (D1).

12. The die positioning method according to the preceding claim, wherein an offset value between the central axis of the bond-head (14) and the center of the die (50) carried by said bond-head (14) is measured using the up-looking camera (18) and wherein said offset value is used to correct the position of the carriage (12) for accurate positioning of the die (50) at the target location (30) independently of the amplitude of the offset value.

13. Die positioning method using the die bonding apparatus (10) according to any of claims 4 to 7, wherein the method comprises following steps:
- finding with the camera (16) a target location for positioning the die,
- recording a misalignment between the camera optical axis and said target location (30),
- moving the carriage (12) as a function of the signal outputs acquired by respective first and second sets of encoder heads to align the bond-head (14) along the X-Y direction and around the Z-axis (Rz) with said target location (30), and
- actuating the die bond-head (14) in the Z-direction to place the die at said target location.
